# EUROPEAN PATENT APPLICATION

(11) **EP 1 729 334 A1**
(43) Date of publication of application: **06.12.2006**
(21) Application number: 05720984.3
(22) Date of filing: 17.03.2005
(51) Int. Cl.: H01L 21/60, B23K 35/26, H01L 23/12, H05K 3/34

(54) **SOLDER COMPOSITION AND METHOD OF BUMP FORMATION THEREWITH**

(30) Priority: 22.03.2004 JP 2004082467
(71) Applicant: Tamura Corporation, Tokyo 178-8511 (JP); Japan Science and Technology Agency, Kawaguchi-shi, Saitama 332-0012 (JP)
(72) Inventor: SAKAMOTO, Isao, c/o TAMURA CORPORATION, Tokyo 1788511 (JP); ONOZAKI, Junichi, c/o TAMURA CORPORATION, Tokyo 1788511 (JP); FURUNO, Masahiko, c/o TAMURA CORPORATION, Tokyo 1788511 (JP); SAITO, Hiroshi, c/o TAMURA CORPORATION, Tokyo 1788511 (JP); ANDO, Haruhiko, c/o TAMURA CORPORATION, Tokyo 1788511 (JP); SHIRAI, Masaru, c/o TAMURA CORPORATION, Tokyo 1788511 (JP); HIRATSUKA, Atsushi, c/o TAMURA CORPORATION, Tokyo 1788511 (JP)
(74) Representative: Whalley, Kevin
(86) International application number: PCT/JP2005/004749
(87) International publication number: WO 2005/091354

(57) **Abstract**

A solder composition capable of in the bump formation on a substrate, simplifying the coating operation. There is provided solder composition (10) comprising a mixture of liquid substance (12) and solder particles (11), wherein the liquid substance (12) contains a flux component of organic acid whose reaction temperature for oxide film removal is in the vicinity of the melting point of the solder particles and has such a viscosity that the liquid substance flows at ordinary temperature and accumulates in the form of a layer on substrate (20). The solder particles (11) consist of a particulate agent that settles in the liquid substance (12) toward a solder base material, having a particle diameter and mixing ratio enabling uniform dispersion in the liquid substance (12). By application of this solder composition onto substrate (20) with pad electrode (22) followed by heating, solder particles (11) adhere to the pad electrode (22) having its surface oxide film removed through reaction with the flux component to thereby promote soldering between any solder film formed on the base material and the solder particles (11), and further, aggregation of the solder particles (11) can be inhibited by a reaction product of the flux component to thereby form unbridged solder bumps (23).

## Description

### TECHNICAL FIELD

The present invention relates to a solder composition and a method of bump formation therewith, which are used when manufacturing FCs (flip chips) and BGAs (ball grid arrays) by forming solder bumps on a semiconductor substrate and interposer substrate, for example.

### BACKGROUND ART

In a typical conventional forming method of solder bumps, solder paste is applied on pad electrodes of a substrate by screen printing or a dispensing method, and the solder paste is heated by reflow oven. The solder paste is also referred to as "cream solder".

Patent Literature 1 discloses an example of the above-described solder paste consisting of a mixture of special solder powder and flux. The solder powder is obtained by forming an oxide film on the surfaces of solder particles by making the solder particles flow in the air. It is noted that the oxide film formed forcibly functions to suppress coalescence of the solder particles against the effect of flux at the reflow process. Thus, it is understood that when performing reflow after applying the solder paste all over the substrate, a solder bridge between the pad electrodes is hard to occur. Therefore, it is suitable for enabling densification and micronization of the pad electrodes. The solder bridge between the pad electrodes is a phenomenon that occurs when the solder particles are united with each other to form a large ball, and come in contact with both of the adjacent pad electrodes.

Patent Literature 1: Japanese Unexamined Patent Publication 2000-94179

### DISCLOSURE OF THE INVENTION

The solder paste has been used in the conventional solder bump forming. However, the solder paste has the following problems.

(1) Equipments such as a printing machine or a dispensing machine are required to apply the solder paste on the substrate, and it takes time and effort to perform printing or dispensing of the same to an accurate position. For example, even if a precise mask becomes unnecessary by being applied entirely, a step for forming the thickness of the solder paste uniformly by using a squeegee, a doctor blade becomes necessary.

It has become difficult with the screen printing and dispensing method to cope with more densification, micronization and increased number of electrodes these days. That is, the screen printing needs to micronize the opening of a metal mask, which causes such issues that the mechanical strength of the metal mask is deteriorated and it becomes hard for the solder paste to be ejected from the opening of the metal mask. In the dispensing method, the solder paste is applied on a large number of pad electrodes one by one. Thus, it becomes unsuitable for mass production as the number of pad electrodes increases.

In the meantime, it is necessary for the solder paste of Patent Literature 1 to form the thickness of the oxide film of the solder particles with a fine precision. The reason is that the solder is not wetted over the pad electrode when the film is too thick, and the solder particles are united with each other when it is too thin. Moreover, the effect of the flux changes in accordance with the state or the kinds of the flux, so that it is also necessary because of these reasons to control the thickness of the oxide film with a fine precision. Meanwhile, densification and micronization of the pad electrodes cannot be achieved without forming the oxide film in a proper film thickness.

An object of the present invention is to provide a solder composition and a method of bump formation therewith that simplifies the step for applying solder paste on a substrate. A further object of the present invention is to provide a solder composition and a method of bump formation therewith that does not require a step for forming an oxide film of solder particles, thereby simplifying the manufacturing step and reliably achieving densification and micronization of the solder bump.

In order to achieve the above object, the solder composition used in the present comprises a mixture of a liquid substance and the solder particle. The liquid substance contains a flux component whose reaction temperature is close to the melting point of the solder particle, which has such a viscosity that it flows at a normal temperature and spread evenly on a base material. The solder particles are granular agents that precipitate in the liquid substance towards the base material, having the mixing ratio and the particle diameter to be uniformly dispersible within the liquid substance.

In the solder composition according to the present invention, the liquid substance containing the flux component flows at a normal temperature and spread evenly on the base material. It is therefore completely different from the solder paste in this respect. In order to attain such characteristic (flow characteristic), it is necessary for the liquid substance to have low viscosity at a normal temperature, the mixing ratio of the solder particles to be low, and the particle diameter of the solder particle to be small. The particle diameter of the solder particle is to be in the range from 35 µm to 1 µm approximately. The diameter of the solder particle is preferable to be 35 µm or less, more preferable to be 20 µm or less, and most preferable to be 10 µm or less.

The solder composition according to the present invention may have a following constitution. The surface oxide films of the solder particles contain only natural oxide film. The flux component of the liquid substance suppresses coalescence of the solder particles by the reaction product thereof, while accelerating soldering between the solder particles and the base material as well as the coalescence of the solder particles with the solder coating formed on the base material. Such flux component has been found by the inventors of the present invention through repeated experiments and studies.

An example of such flux component may be acid. Acid can be classified roughly into inorganic acid (e.g. hydrochloric acid) and organic acid (e.g. fatty acid). Description herein will be provided by referring to the organic acid.

The inventors of the present invention have found that "organic acid has a small effect for uniting the solder particles with each other but a large effect for generating solder wet on the pad electrode". The following (1) and (2) can be considered as the reasons for producing such effects.

(1) Organic acid has a weak effect for eliminating the oxide films of the solder particles. Thus, coalescence of the solder particles can be suppressed by the natural oxide film of the solder particles without intentionally forming the oxide film on the solder particles. Therefore, the present invention requires no step for forming the oxide film on the solder particles. In the related art disclosed in Patent Literature 1, however, the effect of the flux is too strong, and the solder particles are united with each other unless a thick oxide film is formed on the solder particles.

(2) Organic acid has an effect of spreading the solder particles on the base material and forming the intermetallic compound as well as uniting the solder particles with the solder coating formed on the base material. The mechanism that generates the solder wet on the base material having almost no coalescence of the solder particles is not clear. It is assumed that there is some kind of reaction occurred for slightly breaking the oxide film between the solder particles and the base material. For example, with the gold-plated base material, there is generated solder wet due to the diffusion effect of gold into the solder even if there is a thin oxide film on the solder particles, for example. In the case of a base material made of copper, copper reacts with the organic acid and becomes organic acid copper salt. When the organic acid copper salt comes in contact with the solder, it is deoxidized due to a difference of ionization tendencies. Thus, metal copper is diffused into the solder so that the solder wet is promoted. For the reason for uniting the solder particle with the solder coating formed on the base material, the surface tension may be considered, for example.

The liquid substance mixed with the solder particles may be a fat and fatty oil, and the flux component contained in the liquid substance may be free fatty acid contained in the fat and fatty oil. Fats and fatty oils are widely distributed on the market for various purposes, so that they are easily obtained at low cost and are nontoxic as well. In addition, the fat and fatty oil originally contains organic acid (flux component) called free fatty acid. Particularly, fatty ester (e.g. neopentylpolyol ester) is generally excellent in thermal and oxidation stability, so that it is optimum flux component for soldering. Further, for the sufficient content of the free fatty acid as flux component, it is preferable for the acid value of the fat and fatty oil to be 1 or more. The acid value is the amount in milligrams of potassium hydroxide necessary for neutralizing the free fatty acid contained in the fat and fatty oil 1g. That is, the larger acid value indicates that there is more free fatty acid contained.

The fat and fatty oil used in the solder composition of the present invention remain until the solder bumps are completely formed, which prevents the direct contact of the solder and air during that time for suppressing oxidation of the solder. The content of organic acid contained in the fat and fatty oils is controlled so that even though it contributes to eliminate the oxide film on the solder surface, it does not completely eliminate the oxide film of the solder surface. With this, it is possible to achieve the state capable of soldering to the surface of the base material while suppressing coalescence of the solder particles with each other. For the organic acid, there is required the amount sufficient to eliminate the oxide film on the surface of the base material. For that, the acid value of the fat and fatty oil is preferable to be 1 or more.

The solder composition used in the present invention contains organic acid (flux component) in the fat and fatty oil. The organic acid may be either the one originally contained in the fat and fatty oil or the one added afterwards. Organic acid exhibits the effect of deoxidizing the oxide films of the solder particles and the base material. Further, the inventors of the present invention have found that soldering to the base material can be achieved while suppressing coalescence of the solder particles with each other by remaining a slight amount of the oxide film on the surfaces of the solder particles through properly controlling the amount of the organic acid in the fat and fatty oil. Furthermore, the inventors also have found that, when tin is contained in the solder, organic acid tin salt is obtained as a byproduct during the process of deoxidizing the oxide film on the surface of the solder by the organic acid, and the organic acid tin salt dramatically suppresses coalescence of the solder particles. Through controlling these phenomena, it is possible to form the solder bump that does not generate short-circuit on the pad electrode, for example, while preventing coalescence of the solder particles with each other.

A method of forming bumps according to the present invention includes a deposition step for depositing the solder composition according to the present invention on a base material in layers, and a reflow step for heating the solder composition on the base material. When the solder composition according to the present invention is dropped onto the base material, the solder composition spreads by the weight of itself and deposits in layers. The temperature is at a normal temperature, and the free fall of the solder composition is utilized. Thus, the solder composition is easily applied to the base material without using a printing machine or a dispensing machine.

A stirring step for stirring the solder composition to uniformly disperse the solder particles in the liquid substance may be performed before the deposition step. In this case, even if the solder particles precipitate in the liquid substance due to the specific weight difference, the solder particles are uniformly dispersed in the liquid substance and uniformly distributed with respect to the base material by stirring the solder composition.

A spin coating step for horizontally rotating the base material to have the solder composition to a uniform thickness may be performed in the middle of or after the deposition step. Since the extra solder composition on the base material is released by horizontally rotating the substrate, the thickness of the solder composition on the base material can be made uniform rapidly, can be made uniform thinly, and can be made uniform more accurately.

In the deposition step, the base material is arranged in the container, and the base material is immersed in the solder composition in the container by pouring the solder composition. In this case, the thickness of the solder composition on the base material can take an arbitrary value irrespective of the surface tension or viscosity of the solder composition. Further, with the solder paste, the printing thickness or the content of the solder powder are controlled for changing the size (height) of the solder bump. The present invention, on the other hand, does not use a mask, and thus the mask thickness or the opening diameter does not need to be changed as in the prior art when changing the thickness of the solder composition, whereby the size (height) of the solder bump can be easily changed by simply adjusting the dropping amount of the solder composition.

The "solder" herein includes not only those used for forming the solder bumps but also those called "soft solder" and the like used for die-bonding semiconductor chips and for connecting copper pipes, for example. Needless to say, lead-free solder is also included. The "solder bump" is not limited to a hemispherical type or protruded type, but a film type is also included. It is noted that the "solder coating" is not limited to a film type, but a hemispherical type and a protruded type are also included. The "substrate" includes a semiconductor wafer and a wiring board. The "liquid substance" may be a fluid body other than a liquid, and fluorine high-boiling solvent or fluorine oil may be used other than the fat and fatty oils.

According to the solder composition of the present invention, the liquid substance and the solder particles both spread by the weight of itself and deposit in layers when dropped on a flat surface at a normal temperature, and thus can be easily applied on the base material without using the printing machine or the dispensing machine.

Further, according to the solder composition of the present invention, the surface oxidized film of the solder particles is only the natural oxidized film, a special flux component is contained in the liquid substance mixed with the solder particles, the coalescence of the solder particles during the flow is suppressed by the reaction product of the flux component, and the soldering is performed while suppressing the production of the solder bridge as the solder particles spread on the pad electrode and unit with the solder coating on the base material. Further, the manufacturing step is simplified since a step for forming the oxidized film of the solder particles is unnecessary, and further, the soldering is performed densely and finely since an accurate control of the film thickness of the oxidized film is also unnecessary. That is, according to the solder composition of the present invention, since the solder particles barely unite when the solder particles are melted, the solder bumps that in which variation in the solder amount is small and that which does not cause short circuit between the pad electrodes are formed uniform with respect to the pad electrode of narrow pitch.

When the flux component contained in the liquid substance is the organic acid, the organic metal salt produced in the process of removing the natural oxidized film of the solder particles suppresses the coalescence of the solder particles, so that the effect of the flux component is readily obtained.

When the liquid substance mixed with the solder powder is fat, the manufacturing cost is reduced, and the influence on the environment by becoming a waste product is alleviated. Moreover, since the organic acid or the free fatty acid is originally contained in the fat, the addition of the organic acid can be omitted.

When the fat is fatty acid ester, the manufacturing cost is further reduced since the fatty acid ester is the most commonly used fat, and is suitably used in soldering as it excels in thermal and oxidation stability. The fatty acid ester also enhances the stability of the liquid property since the compatibility with the organic acid used as an active material is satisfactory.

When the acid value of the fat and fatty oil is 1 or more, the free fatty acid (flux component) is sufficiently contained therein, and thus the oxidized film of the pad electrode and the solder particles can be appropriately removed, thereby enhancing the solder wetting property.

According to the method of forming the bump of the present invention, the deposition step for depositing the solder composition according to the present invention on the base material in layers, and the reflow step for heating the solder composition are provided, and thus the solder composition is easily applied to the base material without using the printing machine or the dispensing machine and productivity is enhanced.

The solder particles can be distributed uniformly on the base material if the stirring step is performed before the deposition step.

The thickness of the solder composition on the base material can be made uniform rapidly, can be made uniform thinly, and can be made uniform accurately if the spin coating step is performed in the middle of or after the deposition step.

The thickness of the solder composition on the base material can be set to a desired value if the base material is immersed in the solder composition in the deposition step. That is, the size (height) of the solder bump can be easily changed by adjusting the dropping amount of the solder composition.
BRIEF DESCRIPTION OF THE DRAWINGS
Fig. 1 is a cross sectional view showing an embodiment of a solder composition according to the present invention;
Fig. 2 is a cross sectional view showing an embodiment of a method (dropping step) of forming bumps according to the present invention, the steps proceeding in the order of Fig. 2[1] to Fig. 2[3]; and
Fig. 3 is a cross sectional view showing an embodiment of a method (reflow step) of forming bumps according to the present invention, the steps proceeding in the order of Fig. 3[1] to Fig. 3[3].

### BEST MODE FOR CARRYING OUT THE INVENTION

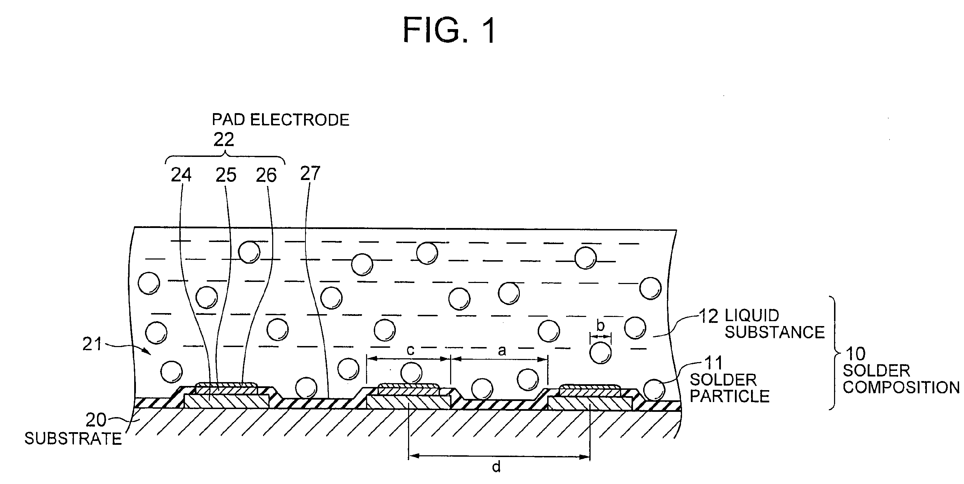

FIG. 1 is a cross section for showing the solder composition according to an embodiment of the present invention. Description will be provided hereinafter by referring to this illustration. FIG. 1 shows the state where the solder composition is applied over the substrate, in which the vertical view thereof is enlarged compared to the lateral view.

The solder composition 10 used in this embodiment is a mixture of a great number of solder particles 11 and the liquid substance 12 made of fatty ester, which is used for forming the solder bumps on the pad electrodes 22. The liquid substance 12 contains a flux component whose reaction temperature is close to the melting point of the solder particle 11, which has such a viscosity that it flows at a normal temperature and deposit in layers on a substrate 20. The solder particles 11 are granular agents that precipitate in the liquid substance 12 towards the substrate 20, having the mixing ratio and the particle diameter to be uniformly dispersible within the liquid substance 12.

Further, the solder particles 11 have only a natural oxide film (not shown) on the surfaces. The liquid substance 12 is fatty ester so that it originally contains free fatty acid (flux component) that is a kind of organic acid. The free fatty acid accelerates the soldering between the solder particles 11 and the pad electrodes 22, while suppressing coalescence of the solder particles 11 by the reaction product thereof when heated to the melting point of the solder particle 11 or higher. At the same time, it exhibits an effect of accelerating coalescence of the solder coating formed on the pad electrodes 22 and the solder particles 11.

The organic acid contained in the liquid substance 12 may be added as necessary. That is, the content of the organic acid in the liquid substance 12 is controlled in accordance with the degree of oxidation and the amount of the solder particles 11. For example, there is required a large amount of the solder particles 11 when forming a large number of solder bumps. Thus, it is necessary to contain sufficient organic acid for deoxidizing the oxide film of all the solder particles 11. In the meantime, when there is added an excessive amount of solder particles 11 that is more than the amount used for forming the bumps, the content of the organic acid is reduced for decreasing the activating power of the liquid substance 12 so that the fine solder particles 11 in terms of the particle size distribution of the solder powder are not melted. With this, it is possible to form the optimum bumps with only the relatively larger solder particles 11. The fine solder particles that are not melted and remained at this time have an effect of decreasing short-circuit of the pad electrodes 22 by preventing coalescence of the solder particles 11.

It is necessary for the solder particles 11 to be uniformly dispersed in the liquid substance 12, so that it is desirable for the solder composition 10 to be stirred right before the use. For the solder particles 11, there is used tin-lead type solder, lead-free solder, or the like. It is preferable for the diameter b of the solder particle 11 to be smaller than the shortest distance a between the peripheral ends of the adjacent pad electrodes 22. In this case, the solder particles 11 that have reached the solder coating on the pad electrode 22 do not contact, and thus do not unite and form the solder bridge.

The solder composition 10 is dropped on the substrate 20 having the pad electrodes 22 by natural fall at a normal temperature. Only with this, the solder composition 10 with a uniform thickness can be applied over the substrate 20. That is, it is possible to form a coating film of the solder composition 10 with a uniform thickness on the substrate 20 without using screen printing and a dispenser. The uniformity of the coating influences the dispersions in the solder bumps, so that it should be applied uniformly as much as possible. Then, the entire substrate 20 is heated uniformly for allowing formation of the solder bumps. The heating temperature is increased to the melting point of the solder or higher in a short time. Through increasing the temperature in a short time, deterioration in the activating force of organic acid during the process can be suppressed.

Next, the substrate 20 used in this embodiment will be described. The substrate 20 is a silicon wafer. The pad electrodes 22 are formed on a top-face 21 of the substrate 20. The solder bumps are formed on the pad electrodes 22 by the forming method of the embodiment. The substrate 20 is connected electrically and mechanically to another semiconductor chip or wiring board through the solder bumps. The shape of the pad electrode 22 is circular, for example, having the diameter c of 40 µm, for example. The distance d between the centers of the adjacent pad electrodes 22 is 80 µm, for example. The diameter b of the solder particle 11 is 3 - 15 µm, for example.

The pad electrode 22 is constituted with an aluminum electrode 24 formed on the substrate 20, a nickel layer 25 formed on the aluminum electrode 24, and a metal layer 26 formed on the nickel layer 25. The nickel layer 25 and the metal layer 26 are UBM (under barrier metal or under bump metallurgy) layers. The part on the substrate 20 other than the pad electrodes 22 is covered by a passivation film 27.

Next, a forming method of the pad electrodes 22 will be described. First, the aluminum electrode 24 is formed on the substrate 20, and the passivation film 27 is formed with a polyimide resin or silicon nitride film over the part except for the aluminum electrode 24. These are formed by using photolithography and etching, for example. After applying zincate treatment on the surface of the aluminum electrode 24, the nickel layer 25 and the metal layer 26 are formed on the aluminum electrode 24 by electroless plating. The UBM layers are provided for supplying the solder wettability to the aluminum electrode 24.

For the solder particles 11, there are used Sn-Pb (melting point at 183°C), Sn-Ag-Cu (melting point at 218°C), Sn-Ag (melting point at 221°C), Sn-Cu (melting point at 227°C), or lead-free solders and the like.

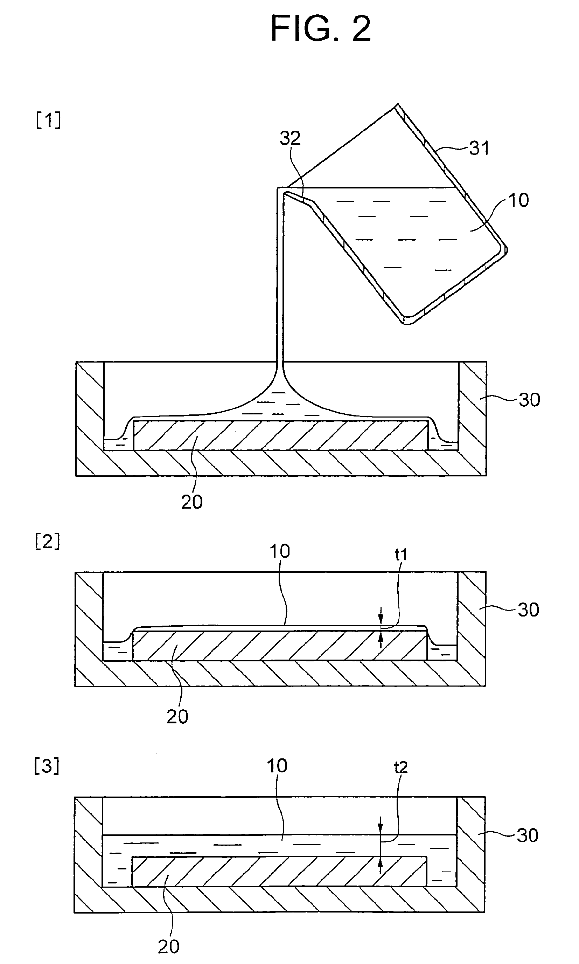

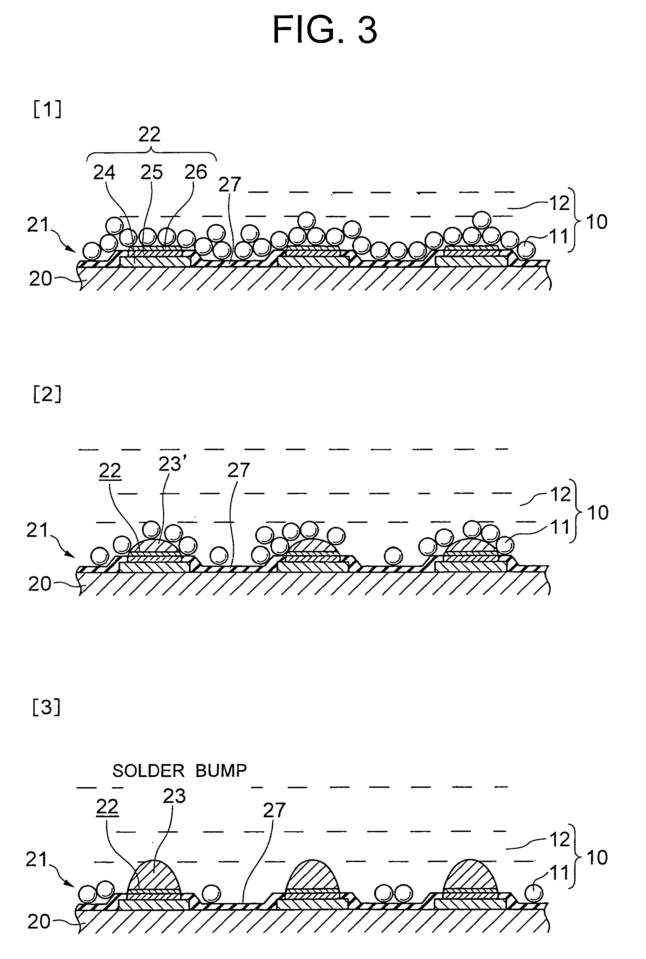

FIG. 2 and FIG. 3 are cross sections for showing an embodiment of the bump forming method according to the present invention. FIG. 2 illustrates the dropping step, which proceeds in order of FIG. 2[1] - FIG. 2[3]. FIG. 3 illustrates the reflow step, which proceeds in order of FIG. 3[1] - FIG. 3[3]. Description will be provided hereinafter by referring to FIG. 1 - FIG. 3. However, the same reference numerals are applied to the components that are same as those of FIG. 1, and the descriptions thereof are omitted.

In FIG. 2, illustrations of the pad electrodes 22 on the substrate 20 are omitted. First, as shown in FIG. 2[1], the substrate 20 is placed in the receiver container 30. Then, after stirring the solder composition 10 in a pouring container 31 as necessary, the solder composition 10 is dropped from a pourer 32 on the substrate 20. Upon this, the solder composition 10 spreads into a uniform thickness by the weight of itself. At this time, the temperature may be at a normal temperature. Moreover, natural fall of the solder composition 10 can be utilized. Thus, the solder composition 10 can be easily applied onto the substrate 20 without using a printing machine or a dispensing machine.

The receiver container 30 is heated along with the substrate 20 in the reflow step. Thus, it is made of a metal such as aluminum that exhibits heat resistance and fine thermal conduction, and causes no solder wet by the solder particles 11. Furthermore, during or after the deposition step, the substrate 20 may be rotated horizontally so that the thickness of the solder composition 10 on the substrate 20 becomes uniform. For rotating the substrate 20 horizontally, a spin-coating device on the market may be used.

End of the deposition step can be classified into two types depending on whether or not the solder composition 10 is dropped until the substrate 20 is immersed in the solder composition 10. FIG. 2[2] shows the case where the substrate 20 is not immersed in the solder composition 10. In this case, thickness t1 of the solder composition 10 deposited in layers on the substrate 20 is a value determined in accordance mainly with the surface tension and the viscosity of the solder composition 10. In the meantime, FIG. 2[3] shows the case where the substrate 20 is immersed in the solder composition 10. In this case, thickness t2 of the solder composition 10 deposited in layers on the substrate 20 can be set as a desired value in accordance with the amount of the solder composition 10 to be dropped.

Through the above-described deposition step, the solder composition 10 is applied solid over the substrate 20 on which a plurality of pad electrodes 22 are provided with a space therebetween as shown in FIG. 1. At this time, the solder composition 10 is applied all over the face including the plurality of the pad electrodes 22 and the passivation film 27 formed between the gaps thereof. The solder composition 10 is in a state just like an ink.

Then, when heating of the substrate 20 and the solder composition 10 is started in the reflow step, the viscosity of the liquid substance 12 is deteriorated further. With this, as shown in FIG. 3[1], the solder particles 11 precipitate and pile up over the pad electrodes 22 and the passivation film 27, since the specific gravity of the solder particles 11 is larger than that of the liquid substance 12.

Subsequently, as shown in FIG. 3[2], the solder composition 10 is heated up to the melting point of the solder particles 11 or higher. At this time, due to the effect of the organic acid (flux component) contained in the liquid substance 12, there is induced a following state. First, coalescence of the solder particles 11 can be suppressed by the reaction product of the organic acid. Although not shown in FIG. 3[2], however, part of the solder particles 11 are united with each other and become larger. In other words, it is not an issue even though the solder particles 11 are united with each other as long as it is in a specific size or smaller. In the meantime, the solder particles 11 spread over the pad electrode 22 and form an alloy layer on the interface. As a result, the solder coating 23' is formed on the pad electrode 22, and the solder particles 11 are united further with the solder coating 23'. That is, the solder coating 23' grows into a solder bump 23 as shown in FIG. 3[3].

In FIG. 3[3], the solder particles 11 that are not used for forming the solder bumps 23 are washed off along with the remaining liquid substance 12 in a latter step.

Other operations and effects of the present embodiment will now be described.

According to the solder composition 10 of the present embodiment, the solder powder (aggregate) is configured from a great number of solder particles 11 having only a natural oxidized film on the surface, an organic acid (flux component) is contained in the liquid substance 12 mixed with the solder powder, the coalescence of the solder particles 11 during the flow is suppressed by the reaction product of the organic acid, and the soldering is performed while suppressing the production of the solder bridge as the solder particles 11 spread on the pad electrode 22 and unit with the solder coating 23' on the pad electrode 22. Further, the manufacturing step is simplified since a step for forming the oxidized film of the solder particles 11 is unnecessary, and further, the soldering is performed densely and finely since an accurate control of the film thickness of the oxidized film is also unnecessary.

According to a bumps forming method according to the present invention, the solder composition 10 of the present embodiment is deposited in layers on the substrate 20 on which a plurality of pad electrodes 22 are arranged spaced apart from each other, and the solder composition 10 on the substrate 20 is heated and flowed, so that solder bumps 23 are formed densely and finely through the function of the organic acid contained in the liquid substance 12. Even if the solder composition 10 is applied entirely and deposited on the substrate 20, the solder particles 11 barely unite with each other during the flow, and thus the solder bridge is suppressed from occurring between the pad electrodes 22, and the solder bumps 23 are formed densely and finely with a simple method.

Needless to say, the present invention is not limited to the above embodiment. For instance, a substrate, an interposer, or the wiring board (BGA) of fine pitch may be used instead of a silicon wafer (FC) for the base material. The electrode material is not limited to aluminum but Al-Si, Al-Si-Cu, Al-Cu, Cu may be used.

### EXAMPLE 1

EXAMPLE 1 as a more concrete example of this embodiment will be described hereinafter.

The solder particles used therein had the composition of Sn(96.5 wt%)-Ag(3.0 wt%)-Cu(0.5 wt%) with the melting point at 218°C, and the average diameter thereof was 6 µm (particle size distribution of 2 - 11 µm). A kind of (trimethylpropanetrioleate) of fatty ester was used for the liquid substance. The main characteristic of fatty ester is that the kinematic viscosity at 40°C is 48.3 mm²/s, the kinematic viscosity at 100°C is 9.2 mm²/s, and the acid value is 2.4. An organic acid (flux component) was not added and free fatty acid (flux component) which is originally contained in fatty ester were utilized. Further, vacuum deaeration with less than the vapor pressure of water was performed on the fatty ester for suppressing the influence of moisture as much as possible.

For the substrate for forming the solder bumps, a silicon chip with 10 mm square was used. On the silicon chip, pad electrodes in 80 µm pitch were formed in a two-dimensional-array form. The shape of the pad electrode was 40 µm square. The material for the top face of the pad electrode was a gold plating with a thickness of a decimal of several microns formed on an electroless nickel plating. The material for the protection film was silicon nitride.

The solder composition in which 2.0g of solder powder was dispersed in 50ml of fatty acid ester was dropped using a micropipette to apply a fixed quantity of 50µl on the entire surface of the substrate. Thereafter, the silicon chip was heated (70°C/min.) to the melting point of the solder or higher on a hot plate to form the solder bump. The yield was 100%.

## Claims

1. A solder composition made of a mixture of a liquid substance and solder particles; wherein
the liquid substance contains a flux component whose reaction temperature is close to the melting point of the solder particle, and having viscosity that flows at a normal temperature and that deposits in layers on a base material; and
the solder particles are granular agents that precipitate in the liquid substance towards the base material, having a mixing ratio and a particle diameter to be uniformly dispersible within the liquid substance.

2. The solder composition as claimed in claim 1, wherein the mixing ratio of the solder particles is less than or equal to 30wt%.

3. The solder composition as claimed in claim 1, wherein the particle diameter of the solder particle is less than or equal to 35µm.

4. The solder composition as claimed in claim 1, wherein only a natural oxidized film is formed on a surface oxidized film of the solder particles.

5. The solder composition as claimed in claim 1, wherein the flux component contained in the liquid substance accelerates the soldering between the solder particles and the base material and accelerates coalescence of the solder particles with the solder coating formed on the base material while suppresses coalescence of the solder particles by the reaction product thereof.

6. The solder composition as claimed in claim 5, wherein the flux component is acid.

7. The solder composition as claimed in claim 6, wherein the acid is an organic acid.

8. The solder composition as claimed in claim 1, wherein the liquid substance is fat.

9. The solder composition as claimed in claim 8, wherein the flux component is free fatty acid contained in the fat.

10. The solder composition as claimed in claim 8, wherein the fat is fatty acid ester.

11. The solder composition as claimed in claim 10, wherein the fatty acid ester is neopentylpolyolester.

12. The solder composition as claimed in claim 8, wherein an acid value of the fat is greater than or equal to one.

13. A method of forming bumps comprising:
deposition step for depositing on a base material a solder composition including a mixture of a liquid substance with flux component whose reaction temperature is close to the melting point of the solder particles, having such a viscosity that flows at normal temperature and that deposits in layers on a base material, and solder particles that precipitate through the liquid substance towards the base material and that have a mixing ratio and a particle diameter to be uniformly dispersible within the liquid substance; and
reflow step for heating the solder composition and forming bumps made up of solder particles on the base material.

14. The method of forming bumps as claimed in claim 13, wherein the solder particles are uniformly dispersed in the liquid substance by stirring the solder composition in a pre-stage of the deposition step.

15. The method of forming bumps as claimed in claim 13, wherein the solder composition is spin coated to a uniform thickness by rotating the base material in the deposition step.

16. The method of forming bumps as claimed in claim 13, wherein the solder composition is poured into a container arranged with the base material, and the base material is immersed in the solder composition in the deposition step.
